# EUROPÄISCHE PATENTANMELDUNG

(11) **EP 2 228 910 A2**
(43) Veröffentlichungstag der Anmeldung: **15.09.2010**
(21) Anmeldenummer: 10002613.7
(22) Anmeldetag: 12.03.2010
(51) Int. Cl.: H04B 1/10

(54) **Verfahren zur Unterscheidung von Rauschen und Nutzsignalen**

(30) Priorität: 13.03.2009 DE 102009013037
(71) Anmelder: EADS Deutschland GmbH, 85521 Ottobrunn (DE)
(72) Erfinder: Kottke, Thomas, Dr., 71139 Ehningen (DE); Kempter, Roland, Dr., 88048 Friedrichshafen (DE)
(74) Vertreter: Meel, Thomas

(57) **Zusammenfassung**

Die Erfindung betrifft ein Verfahren zur Unterscheidung von Rauschen und Nutzsignalen im Empfangssignal eines Radioempfängers, bei dem eine Rauschabschätzung im Frequenzbereich durchgeführt wird.

## Beschreibung

Die Erfindung betrifft ein Verfahren zur Unterscheidung von Rauschen und Nutzsignalen im Empfangssignal eines Radioempfängers, z.B. eines analogen oder digitalen Funkgeräts für den Sprech- und Datenfunk.

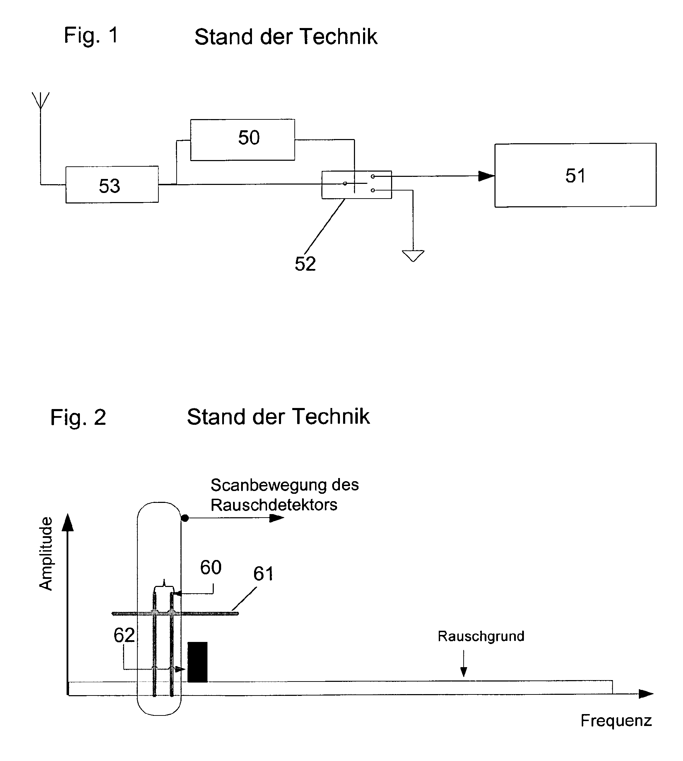

Ein wesentliches Problem in Radio-Empfängern ist die korrekte und zuverlässige Unterscheidung von Rauschen und wirklichen Kommunikationssignalen in der Detektorstufe vor oder auch nach den eigentlichen Demodulatoren. Nur wenn diese Unterscheidung mit hoher Wahrscheinlichkeit und hoher Geschwindigkeit bei verschiedensten Signalarten getroffen werden kann, wird eine Überlastung des Empfängersystems (wozu letztendlich auch der Bediener gehört), vermieden. Typischerweise werden für diese Aufgabe sogenannte Squelchdetektoren 50 (Fig. 1) eingesetzt, die, abgestimmt auf die Natur des zu detektierenden Signals (Pegel, Bandbreite oder auch komplexere Signalcharakteristika), versuchen, eine Vorentscheidung Signal/Rauschen zu treffen und dementsprechend das Eingangssignal über einen Schalter 52 entweder auf weitere Empfangsglieder 51 (z.B. Demodulator, Detektor, AD-Wandler, Bediener etc) oder auf einen Abschlusswiderstand leiten. Mit Bezugsziffer 53 ist das Antennenfrontend bezeichnet.

Aus dem Gesagten folgt, dass nach dem Stand der Technik die genannten Eigenschaften des Signals bekannt sein müssen. Des Weiteren sind klassische Squelchdetektoren nicht bei allen Signalarten anwendbar - so ist eine automatische Erkennung von bandgespreizten Signalen (Spread Spektrum) oder auch Sendungen mit unterdrücktem Trägersignal sehr schwierig oder unmöglich.

Die Arbeitsweise eines bekannten, pegelgesteuerten Squelchdetektors ist in Fig. 2 dargestellt. Ein schmalbandiger Detektionsbereich 60 wird über die Frequenz bewegt, um das gesamte relevante Spektrum sequentiell zu erfassen. Hierfür hat ein Benutzer/Dekoderglied interaktiv einen Pegelschwellwert 61 eingestellt, unterhalb/oberhalb dessen ein Signal 62 als Rauschen/echtes Signal klassifiziert wird. Wie man aus Fig. 2 erkennt, ist der gegenwärtig eingestellte Pegel-Schwellenwert 61 zu hoch, um das Nutzsignal 62 zu detektieren.
Typischerweise wird für diese Schwellwerteinstellung ein Trägersignal benötigt, welches durch ein sehr schmalbandiges Bandpassfilter vorselektiert werden muss. Der Pegelvergleich mit dem eingestellten Schwellenwert erfolgt dann nach diesem Filter.

Die Nachteile eines solchen Squelchdetektors sind vielfältig:
- Es muss ein Regelglied realisiert werden (menschlich oder automatisch), welches den Pegel-Schwellenwert nachführt, ggf. bis hinunter zum Hintergrundrauschen um sicherzustellen, dass eine mögliche Sendung detektiert werden kann.
- Diese Nachführung muss über sequenziell über den gesamten beobachteten Frequenzbereich und dort für jede mögliche Trägerfrequenz über einen weiten Pegelbereich durchgeführt werden, um eine hohe Erkennungsquote gewährleisten zu können.
- Befinden sich das Squelchglied und das Regelglied an unterschiedlichen Orten, so kann sich die Laufzeit des Regelsignals negativ auf die Abstimmgeschwindigkeit des Squelchgliedes auswirken. Offensichtlich erzwingt eine hohe Detektionswahrscheinlichkeit unbedingt eine lange Beobachtungsdauer pro Frequenzabschnitt.

Der Erfindung liegt die Aufgabe zugrunde, ein Verfahren zur Unterscheidung von Rauschen und Nutzsignalen anzugeben, mit dem die oben genannten Nachteile der bekannten Squelchdetektoren vermieden werden.

Diese Aufgabe wird mit einem Verfahren nach Patentanspruch 1 gelöst. Vorteilhafte Ausführungen der Erfindung sowie ein Radioempfänger, in dem das erfindungsgemäße Verfahren implementiert ist, sind Gegenstände weiterer Ansprüche.

Das erfindungsgemäße Verfahren unterscheidet das Nutzsignal im Empfangssignal eines Radioempfängers vom Rauschen durch eine Rauschabschätzung im Frequenzbereich.

In einer besonders vorteilhaften Ausführung erfolgt dabei eine breitbandige, mehrkanalige Analyse des Einganssignals mit anschließender automatischer Leistungswertschätzung der Pegel in den einzelnen Kanälen des Pegeldetektors. Anstatt einen absoluten Pegelschwellenwert vorzugeben, der zwischen Rauschen und Signal unterscheidet, werden die Leistungswerte in den einzelnen schmalbandigen Kanälen miteinander verglichen. Sobald zwischen den Kanälen ein relativer Pegelunterschied erkannt wird, wird ein Einganssignal als solches erkannt, und im Empfänger an die folgenden Verarbeitungsglieder weitergeleitet.

Die Erfindung ist besonders vorteilhaft einsetzbar bei analogen und digitalen Funkgeräten, wie sie für den Sprech- und Datenfunk verwendet werden.

Die Erfindung weist insbesondere die folgenden Vorteile auf:
- Das erfindungsgemäße Verfahren arbeitet vollautomatisch. Es kommt ohne Benutzerinteraktion aus, und es ist auch keine a-priori Kenntnis des zu erkennenden Signals notwendig. Zusätzlich arbeitet die neue Lösung auch zuverlässig bei Spreizsignalen mit sehr geringer spektraler Effizienz und/oder Sendungen mit unterdrücktem Trägersignal.
- Der beim Einsatz der bekannten Squelchdetektoren notwendige Zeitversatz, wenn die Einstellung des Squelchdetektors von einem räumlich vom Empfänger entfernten Bediener erfolgt (z.B. bei einer Satellitenverbindung mehrere Sekunden), wird vermieden. Insbesondere wird dadurch auch die mit der Totzeit verbundene Gefahr einer vollständigen Instabilität der Regelung vermieden.
- Um die erwähnte Totzeit bei Verwendung des bekannten Squelchdetektors zu vermeiden, wird oftmals das Basisbandsignal oder die ZF vom HF-Empfänger zum Bediener übertragen und es erfolgt erst beim Bediener die Einstellung des Squelchdetektors und die Demodulation. Dies erfordert eine höhere Datenrate als die Übertragung des reinen Nutzsignals und verschwendet kostbare Ressourcen. Diese Probleme können mit der erfindungsgemäßen Lösung vermieden werden.
- Die bei den bekannten Squelchdetektoren bestehende Gefahr, dass aufgrund einer fehlerhaften Einstellung des Squelchpegels Nutzinformationen verloren gehen oder Sendungen undetektiert bleiben, wird vermieden.
- Die erfindungsgemäße Rausch/Signaldetektion arbeitet eingangseitig sehr breitbandig - die Aufspaltung in mehrere parallele schmalbandige Kanäle erfolgt in der Filterbankstufe des Detektors. Daraus folgt, dass die Erkennungsgeschwindigkeit dramatisch gesteigert werden kann. Bei einer erfindungsgemäßen Ausführung von 4096 schmalbandigen Kanälen (hierbei handelt es sich um einen typischer Wert, aber jede andere Kanalzahl der Form 2^n ist möglich), von denen jeder einzelne der Bandbreite eines klassischen Squelchdetektors entspricht, und unter der Annahme, dass ein typischer Squelchdetektor nach dem Stand der Technik 12 interaktive Pegeleinstellungen benötigt (entsprechend einer Auflösung von 12 bit) um ein Signal mit sehr geringer Leistung zu erkennen, so beschleunigt die Erfindung die Erkennung um einen Faktor von 4096*12.

Das erfindungsgemäße Verfahren kann auch benutzt werden, um zu erkennen, ob bei einer frequenzmodulierten Sendung mit dauerhaftem Trägersignal ein Nutzsignal aufmoduliert ist oder ob es sich um eine Sendung handelt, die nur aus dem Trägersignal besteht. Hierbei wird über die einzelnen Filterstufen das Spektrum um den Träger analysiert. Ist die ganze Energie in einem engen Frequenzbereich um den Träger vorhanden (typischerweise <100Hz), so wird nur der Träger gesendet. Ist auch ein einem größeren Frequenzhub Energie vorhanden, so werden Nutzsignale gesendet.

Das erfindungsgemäße Verfahren kann auch für ein Fingerprinting des Senders genutzt werden, da hiermit das Phasenrauschen des Senders sehr fein ausgemessen werden. Dies stellt eine Charakteristik bei vielen Funkgeräten dar.

Die die erfindungsgemäße Detektion von Rauchen/Nutzsignalen kann wahlweise vor oder nach der FM-Demodulation des Empfangsignals erfolgen. Soweit die Detektion erst nach der FM-Demodulation erfolgt, wird ausgenutzt, dass wenn der FM-Demodulator Rauschen demoduliert, an dessen Ausgang ebenfalls ein Rauschsignal vorliegen wird.

Die Erfindung wird anhand von Ausführungsbeispielen unter Bezugnahme auf Figuren näher erläutert. Es zeigen:
- Fig. 1: den Aufbau eines Funkempfängers mit Squelchdetektor nach dem Stand der Technik;
- Fig. 2: die Darstellung der Arbeitsweise eines Squelchdetektors nach dem Stand der Technik;
- Fig. 3: den Aufbau eines Funkempfängers mit erfindungsgemäßem Squelchdetektor;
- Fig. 4: die Arbeitsweise eines erfindungsgemäßen Squelchdetektors.

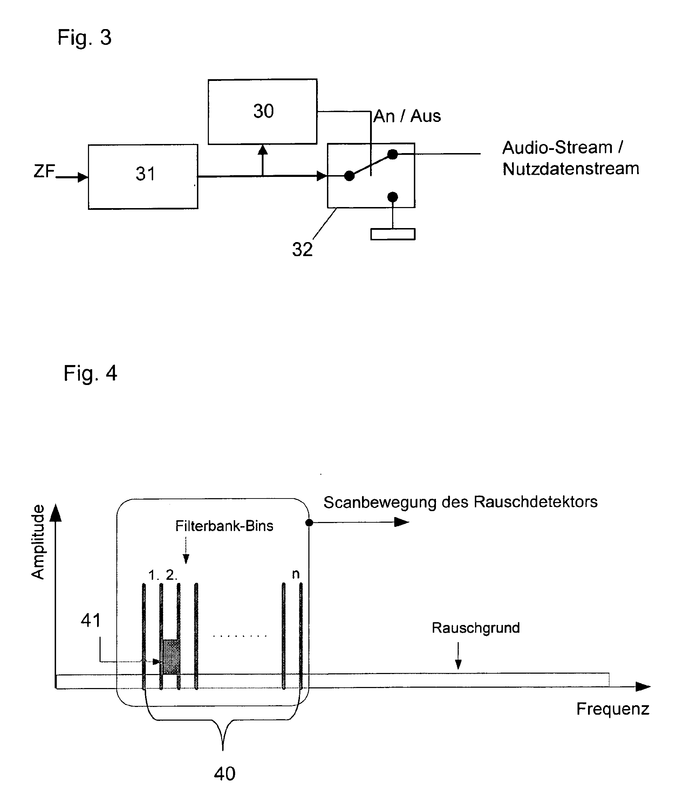

Fig. 3 beschreibt den Aufbau eines Radioempfängers mit erfindungsgemäßem Squelchdetektor 30. Das Zwischenfrequenzsignal ZF vom Antennenfrontend wird vom FM-Demodulator 31 demoduliert. Das demodulierte Signal wird anschließend vom Detektor 30 unter Anwendung des erfindungsgemäßen Verfahrens analysiert. Je nachdem, ob ein Signal (in diesem Beispiel ein Audiosignal oder ein sonstiger Nutzdatenstrom) oder ein Rauschen detektiert wird, wird das Eingangssignal über den Schalter 32 entweder den weiteren Empfangsgliedern oder einem Abschlusswiderstand zugeleitet. Aufgrund der beschriebenen erfindungsgemäßen Arbeitsweise ist der Detektor auch in der Lage, Sprachsignale, unabhängig von der konkret verwendeten Sprache, als Nutzsignale zu erkennen. Spracherkenner würden z.B. bei weniger bekannten Sprachen, die auf Klicklauten basieren versagen. Ebenso werden bei der erfindungsgemäßen Rauschdetektion FSK-Signale oder digitale Datenübertragungen weitergeleitet, was bei einem Spracherkenner nicht der Fall wäre.

Das in Fig. 3 gezeigte System kann sich z.B. an Bord eines Luft- oder Raumfahrzeugs befinden (z.B. einem UAV, Unmanned Aerial Verhicle oder einem Satelliten). Das demodulierte Nutzsignal kann z.B. an eine Bodenstation übertragen werden. Da das erfindungsgemäße Verfahren vollautomatisch arbeitet, ist keine Interaktion mit einem entfernten Bediener in einer Bodenstation notwendig. Die erwähnte Totzeit bei der Fernbedienung kann somit nicht auftreten.

Fig. 4 beschreibt die Arbeitsweise des erfindungsgemäßen Verfahrens. Der breitbandige Detektionsbereich 40 setzt sich aus 1 bis n Filterbank-Kanälen ("Bins") zusammen, die gleichzeitig einen um den Faktor n gegenüber dem Stand der Technik erweiterten Frequenzbereich abdecken. Zur Realisierung der erfindungsgemäßen Frequenzanalyse kann auf Filterbank-Multiträger-Technologien zurückgegriffen werden, wie sie z.B. aus Farhang-Boroujeny und Roland Kempter: "Multicarrier communication techniques for spectrum sensing and communication in cognitive radios", in IEEE Communications Magazine, April 2008, Volume: 46, Issue: 4, page(s): 80-85 bekannt sind.

Es erfolgt eine Leistungswertabschätzung der Pegel in den einzelnen Kanälen 1- n. Das Signal 41 im 2. Bin wird erkannt, da die Rauschleistungen in den anderen Bins geringer sind. Der Detektionsbereich 40 wird über das gesamte relevante Spektrum geführt. Dazu wird im nächsten Schritt der dargestellte Detektionsbereich 40 rechts an die Frequenzkante des n. bins gelegt, so dass sich ein analysierter Gesamtfrequenzbereich ohne Lücken oder Überlapp ergibt.

## Patentansprüche

1. Verfahren zur Unterscheidung von Rauschen und Nutzsignalen im Empfangssignal eines Radioempfängers **gekennzeichnet durch** eine Rauschabschätzung im Frequenzbereich.

2. Verfahren zur Unterscheidung von Rauschen und Nutzsignalen im Empfangssignal eines Radioempfängers nach Anspruch 1, **gekennzeichnet durch** eine breitbandige, in mehreren schmalbandigen Frequenzkanälen parallel ablaufende Analyse des Einganssignals mit nachfolgender Leistungswertschätzung der Pegel in den einzelnen Kanälen und Vergleich der Leistungswerte in den einzelnen Kanälen untereinander, wobei ein Nutzsignal **durch** unterschiedliche Leistungswerte in den einzelnen Verarbeitungskanälen als solches erkannt wird und an die nachfolgenden Verarbeitungsglieder des Radioempfängers weitergeleitet wird.

3. Verfahren nach Anspruch 1 oder 2, **dadurch gekennzeichnet, dass** es vor oder nach einer FM-Demodulation des Empfangssignals vorgenommen wird.

4. Verfahren nach einem der Ansprüche 1 bis 3, **dadurch gekennzeichnet, dass** zur Analyse eines frequenzmodulierten Empfangsignals, welches ein dauerhaftes Trägersignal aufweist, die Leistungswerte in den einzelnen Frequenzkanälen in der Umgebung des Trägersignals ermittelt werden, wobei ein aufmoduliertes Nutzsignal daran erkannt wird, ob die Signalenergie innerhalb eines vorgegebenen Frequenzbereich um das Nutzsignal herum verteilt ist oder nicht.

5. Verfahren nach einem der Ansprüche 1 bis 4, **dadurch gekennzeichnet, dass** zur Analyse eines frequenzmodulierten Empfangssignals, welches ein dauerhaftes Trägersignal aufweist, die Leistungswerte in den einzelnen Frequenzkanälen in der Umgebung des Trägersignals ermittelt werden, um daraus das Phasenrauschen des Senders zu ermitteln.

6. Radioempfänger mit einem Squelchdetektor (30), der zur Durchführung eines Verfahrens nach einem der vorangehenden Ansprüche eingerichtet ist, sowie einem FM-Demodulator (31), **dadurch gekennzeichnet, dass** das Ausgangssignal des FM-Demodulators (31) an den Eingang des Squelchdetektors (30) geleitet wird.

7. Radioempfänger nach Anspruch 5, **dadurch gekennzeichnet, dass** ein vom Squelchdetektor (30) gesteuerter Schalter (32) vorhanden ist, der das Ausgangssignals des FM-Demodulators (31) nur dann weiterleitet, wenn der Squelchdetektor (30) ein Nutzsignal detektiert hat.
